Europäisches Patentamt

European Patent Office

Office européen des brevets

(19)

(11) **EP 1 446 884 B1**

(12) **EUROPÄISCHE PATENTSCHRIFT**

(45) Veröffentlichungstag und Bekanntmachung des Hinweises auf die Patenterteilung:
**28.12.2005 Patentblatt 2005/52**

(21) Anmeldenummer: 02776822.5

(22) Anmeldetag: **15.10.2002**

(51) Int Cl.$^7$: **H03L 1/00**

(86) Internationale Anmeldenummer:
**PCT/DE2002/003907**

(87) Internationale Veröffentlichungsnummer:
**WO 2003/047108 (05.06.2003 Gazette 2003/23)**

(54) **TEMPERATURSTABILISIERTER OSZILLATOR-SCHALTKREIS**

TEMPERATURE-STABILISED OSCILLATOR CIRCUIT

CIRCUIT OSCILLATEUR STABILISE EN TEMPERATURE

(84) Benannte Vertragsstaaten:
**DE**

(30) Priorität: **22.11.2001 DE 10157292**

(43) Veröffentlichungstag der Anmeldung:
**18.08.2004 Patentblatt 2004/34**

(73) Patentinhaber: **Infineon Technologies AG
81669 München (DE)**

(72) Erfinder:
• **HÖLLINGER, Werner
A-9500 Villach (AT)**

• **MOTZ, Mario
A-9241 Wernberg (AT)**

(74) Vertreter: **Graf Lambsdorff, Matthias
Patentanwälte
Lambsdorff & Lange
Dingolfinger Strasse 6
81673 München (DE)**

(56) Entgegenhaltungen:
**EP-A- 0 219 994     EP-A- 0 944 169
WO-A-99/38260       FR-A- 2 783 372
US-A- 5 352 934     US-A- 5 760 657
US-A- 6 157 270**

**Beschreibung**

Die Erfindung bezieht sich auf einem Oszillator-Schaltkreis, welcher auf zyklischem Laden und Entladen eines Ladungsspeichers basiert. Insbesondere betrifft die Erfindung einen Oszillator-Schaltkreis, der einen Arbeitstakt für Geräte im Bereitschaftsbetrieb bereitstellt.

Integrierte Schaltkreise beziehen ihren Arbeitstakt während des Normalbetriebs in der Regel von einem Quarz-Oszillator. Während des Bereitschaftsbetriebs (Stand-by-Betrieb) werden integrierte Schaltkreise häufig von einem Oszillator-Schaltkreis oder einem Phasenschieberoszillator-Schaltkreis mit dem Arbeitstakt versorgt, da diese Schaltkreise sich durch eine geringe Stromaufnahme auszeichnen.

Oszillator-Schaltkreise weisen einen Ladungsspeicher auf, welcher von einer Aufintegrations-Stromquelle bzw. von einer Abintegrations-Stromquelle abwechselnd geladen und entladen wird. Der Ladungsspeicher ist ferner mit einem Komparator verbunden, welcher den Ladezustand des Ladungsspeichers misst und bei Erreichen einer vorgegebenen oberen Komparatorschwelle von dem Lade- in den Entladevorgang umschaltet. Entsprechend wird bei einem Absinken des Ladezustands auf eine untere vorgegebene Komparatorschwelle der Entladevorgang deaktiviert und stattdessen der Ladevorgang aktiviert.

Derartige Oszillator-Schaltkreise, die sich zur Integration in einen integrierten Schaltkreis eignen, sind beispielsweise beschrieben in den Artikeln "A 1.2-µm CMOS Current-Controlled Oscillator" von Michael P. Flynn und Sverre U. Lidholm, erschienen in IEEE Journal of Solid-State Circuits, Band 27, Nr. 7, Juli 1992, Seiten 982-987, und "A Novel CMOS Multivibrator" von I. M. Filanovsky und H. Baltes, erschienen in Analog Integrated Circuits and Signal Processing, Band 2, 1992, Seiten 217-222, und "A novel low voltage low power oscillator as a capacitive sensor interface for portable applications" von Giuseppe Ferri und Pierpaolo De Laurentiis, erschienen in Sensors and Actuators, Band 76, 1999, Seiten 437-441. Bei den in diesen Artikeln vorgestellten Oszillator-Schaltkreisen ist als Ladungsspeicher jeweils ein Kondensator vorgesehen.

Das den Oszillator-Schaltkreisen zugrunde liegende Prinzip eines Univibrators ist in Abbildung 6.50 auf Seite 618 des Buchs "Halbleiter-Schaltungstechnik" von Ulrich Tietze und Christoph Schenk, erschienen im Springer-Verlag, Berlin, 1999, 11. Auflage, dargestellt.

Für Anwendungen eines Oszillator-Schaltkreises im Telekommunikationsbereich ist eine hohe Frequenzstabilität erforderlich. Daher wird die freilaufende Frequenz eines Oszillator-Schaltkreises mit der Quarzfrequenz durch digitale Teilerverhältnisse abgeglichen. Ferner soll die von einem Oszillator-Schaltkreis erzeugte Frequenz weitgehend unabhängig von Temperaturschwankungen, Betriebsspannungsschwankungen, Phasenrauschen sowie Technologie-Streuungen sein. Außerdem soll der Oszillator-Schaltkreis eine geringe Betriebsspannung benötigen, eine geringe Betriebsspannungsabhängigkeit aufweisen, wenig Chipfläche verbrauchen und in einen integrierten Schaltkreis implementierbar sein.

Die vorstehend genannten Qualitätsanforderungen an Oszillator-Schaltkreise gelten auch für Anwendungen in Sensoren. Jedoch ist bei derartigen Anwendungen ein Abgleich auf eine sehr genaue Quarzfrequenz meist nicht erforderlich.

Zur Erzielung einer möglichst großen Stabilität der Oszillatorfrequenz gegenüber Temperaturschwankungen ist es bekannt, Oszillator-Schaltkreise mit Widerständen zu versehen, die unterschiedliche Temperaturkoeffizienten aufweisen. Nachteilig an einer derartigen Kompensation von Temperaturschwankungen ist jedoch, dass technologisch bedingte Streuungen sowohl der Temperaturkoeffizienten als auch der Absolutwerte der verwendeten Widerstände eine nur geringe Temperaturstabilität der Oszillatorfrequenz bewirken.

Ferner ist es bekannt, eine Temperaturstabilität der Oszillatorfrequenz durch zusätzliche externe Bauelemente, wie z.B. externe Widerstände, mit geringen Temperaturkoeffizienten oder durch einen Abgleich auf dem Wafer mittels eines EEPROMs oder durch Zener-Zapping zu bewirken. Diesen bekannten Maßnahmen ist ein großer Herstellungsaufwand mit den damit verbundenen hohen Kosten gemeinsam.

In der europäischen Offenlegungsschrift EP 0 219 994 A2 ist ein Schaltkreis zur Erzeugung eines temperaturstabilisierten Oszillator-Signals beschrieben. In dem Schaltkreis wird mittels eines geeignet beschalteten MOS-Transistors ein temperaturunabhängiger Strom erzeugt. Mit diesem Strom wird ein Schmitt-Trigger gesteuert, welcher das temperaturunabhängige Oszillator-Signal erzeugt.

Aufgabe der Erfindung ist es, einen Oszillator-Schaltkreis zu schaffen, durch welchen der Temperaturkoeffizient der Oszillatorfrequenz auf einen vorgegebenen Wert einstellbar ist und durch welchen insbesondere eine hohe Temperaturstabilität der Oszillatorfrequenz, eine Betriebsspannungsunterdrückung und ein geringes 1/f-Rauschen erzielt wird.

Die der Erfindung zugrunde liegende Aufgabenstellung wird durch die Merkmale des Patentanspruchs 1 gelöst. Vorteilhafte Weiterbildungen und Ausgestaltungen der Erfindung sind in den Unteransprüchen angegeben.

Ein erfindungsgemäßer temperaturstabilisierter Oszillator-Schaltkreis arbeitet nach dem Prinzip des zyklischen Ladens und Entladens eines Ladungsspeichers. Dazu umfasst der Oszillator-Schaltkreis als Bauelemente den Ladungsspeicher, eine steuerbare Aufintegrations-Stromquelle zum Laden des Ladungsspeichers, eine steuerbare Abintegrations-Stromquelle zum Entladen des Ladungsspeichers, einen ersten Widerstand und einen zweiten Widerstand. Der erfindungsgemäße Oszillator-Schaltkreis enthält des Weiteren eine Bandabstands-Referenzschaltung, welche eine Referenzspannung bereitstellt. Die Bandabstands-Referenzschaltung enthält den ersten Widerstand, über welchen die von der Bandabstands-Referenzschaltung erzeugte Referenzspannung abfällt. Über den zweiten Widerstand fällt eine Spannung ab, die proportional zu der Referenzspannung ist. Des weiteren besitzen die beiden Widerstände im Wesentlichen gleiche Temperaturkoeffizienten und sind vorzugsweise auch vom gleichen Widerstandstyp. Dabei gibt der Temperaturkoeffizient die Änderung des Widerstandswerts mit einer Temperaturänderung an. Unter einem Widerstandstyp wird die Art des Widerstands, wie z.B. ein Kohleschichtwiderstand oder ein Metallschichtwiderstand, verstanden.

Der erfindungsgemäße Oszillator-Schaltkreis umfasst ferner einen Komparator, einen ersten Schaltungszweig und einen zweiten Schaltungszweig. Der Komparator steuert die Aufintegrations- und die Abintegrations-Stromquellen. Diese Steuerung führt der Komparator in Abhängigkeit von dem Ladezustand des Ladungsspeichers, einer vorgegebenen unteren Komparatorschwelle und einer vorgegebenen oberen Komparatorschwelle durch. Der erste Schaltungszweig enthält die steuerbare Aufintegrations-Stromquelle oder die steuerbare Abintegrations-Stromquelle, und der zweite Schaltungszweig enthält den Komparator und/oder dient zur Erzeugung der unteren und der oberen Komparatorschwelle.

Durch den ersten Schaltungszweig und/oder den zweiten Schaltungszweig fließen jeweils zumindest zeitweise zwei einander überlagerte Teilströme, die unterschiedliche Temperaturabhängigkeiten besitzen. Beispielsweise kann vorgesehen sein, dass in den Schaltungszweigen jeweils aus den beiden Teilströmen eine Summe oder eine Differenz gebildet wird. Des Weiteren können die beiden Teilströme vorzugsweise gegenläufige oder zumindest unterschiedliche Temperaturabhängigkeiten aufweisen. Durch derartige Teilströme, deren Temperaturabhängigkeiten sich gegenseitig kompensieren, kann der gewünschte Temperaturkoeffizient der Oszillatorfrequenz in einfacher Weise technologisch unabhängig eingestellt werden. Des Weiteren lässt sich durch diese Maßnahmen eine Anordnung zur Kompensation von Temperaturabhängigkeiten mit einem nur geringen Flächenbedarf sowie einem geringen Stromverbrauch realisieren.

Um eine möglichst temperaturstabile Oszillatorfrequenz zu erhalten, werden die einander überlagerten Teilströme in dem ersten und dem zweiten Schaltungszweig und insbesondere auch Teilströme in mindestens einem weiteren Schaltungszweig so dimensioniert, dass lineare und quadratische Terme und insbesondere auch Terme höherer Ordnung der Temperaturabhängigkeit der Oszillatorfrequenz kompensiert werden. Dadurch werden Krümmungen des Temperaturgangs der Oszillatorfrequenz verringert. Die Teilströme können beispielsweise in der Bandabstands-Referenzschaltung erzeugt werden.

Eine Temperaturänderung wird bei dem erfindungsgemäßen Oszillator-Schaltkreis durch die gegenläufigen oder zumindest unterschiedlichen Temperaturabhängigkeiten von zwei Schaltungsteilen des Oszillator-Schaltkreises kompensiert. Ändert sich die Temperatur, so steigt eine elektrische Eigenschaft, durch die der eine Schaltungsteil bestimmt ist, an und eine andere elektrische Eigenschaft, welche den anderen Schaltungsteil bestimmt, fällt gleichzeitig oder steigt mit unterschiedlichem Temperaturkoeffizienten. Insgesamt erfolgt dadurch ein Ausgleich zwischen den beiden elektrischen Eigenschaften, sodass beispielsweise die Summe oder die Differenz oder das Produkt der beiden elektrischen Eigenschaften über einen gewissen Temperaturbereich konstant bleiben. Dadurch können letztlich die Temperaturabhängigkeiten derjenigen Größen eingestellt werden, welche die Oszillatorfrequenz bestimmen. Somit kann der Temperaturkoeffizient der Oszillatorfrequenz auf einen vorgegebenen Wert eingestellt werden und insbesondere kann eine hohe Temperaturstabilität der Oszillatorfrequenz erzielt werden.

Ferner ist es bei dem erfindungsgemäßen Oszillator-Schaltkreis von Vorteil, dass die beiden Widerstände im Wesentlichen die gleichen Temperaturkoeffizienten aufweisen und insbesondere auch vom gleichen Widerstandstyp sind. Dadurch wird die Temperaturabhängigkeit der Oszillatorfrequenz weiter minimiert. Bei einigen bekannten Oszillator-Schaltkreisen wird das gegenteilige Prinzip angewandt, d.h. es werden zum Zweck der Temperaturkompensation Widerstände mit unterschiedlichen oder gegenläufigen Temperaturkoeffizienten verwendet. Durch technologische Streuungen der Widerstände wird dabei jedoch insgesamt eine schlechtere Temperaturkompensation als durch die vorliegende Erfindung erzielt.

Durch die Bandabstands-Referenzschaltung kann vorzugsweise zumindest einer der Teilströme bestimmt werden. Ferner ist es vorteilhaft, wenn die Bandabstands-Referenzschaltung mit dem ersten und/oder mit dem zweiten Schaltungszweig über mindestens einen Stromspiegel verbunden ist.

Vorteilhaft an den auf die Bandabstands-Referenzschaltung bezogenen Maßnahmen ist, dass durch die Bandabstands-Referenzschaltung ein Teilstrom erzeugt werden kann, welcher in seiner Temperaturabhängigkeit einem anderen Teilstrom entgegenwirkt und somit insgesamt eine Kompensation der Temperaturabhängigkeiten bewirkt. Der andere Teilstrom kann dabei beispielsweise vorgegeben sein und als Ladestrom des Ladungsspeichers oder zur Erzeugung der Komparatorschwellen dienen.

Vorteilhaft ist es ebenfalls, wenn der mindestens eine Stromspiegel für einen dynamischen Bauelementeaustausch (dynamic element matching) ausgelegt ist. Der Bauelementeaustausch kann beispielsweise von einer Steuereinheit gesteuert werden und mit dem von dem Oszillator-Schaltkreis bereitgestellten Arbeitstakt getaktet sein. Da durch diese Maßnahme Matchingfehler zwischen den Bauelementen weitgehend unterdrückt werden, resultiert daraus eine noch höhere Genauigkeit und Temperaturstabilität der Oszillatorfrequenz.

Eine weitere besonders vorteilhafte Ausgestaltung der Erfindung ist dadurch gekennzeichnet, dass der erfindungsgemäße Oszillator-Schaltkreis mindestens einen Stromspiegel enthält, welcher ausgangsseitig den ersten und/oder den zweiten Schaltungszweig speist und an dessen Ausgang ein dritter Widerstand geschaltet ist. Der dritte Widerstand weist insbesondere den gleichen Temperaturkoeffizienten und/oder den gleichen Widerstandswert wie der erste und der zweite Widerstand auf.

Der vorstehend beschriebenen Schaltungsanordnung liegt das Prinzip einer Sourcedegenerations-Schaltung zugrunde. Bei einer derartigen Schaltung wird ausgenutzt, dass ein Stromspiegel, welcher grundsätzlich temperaturunabhängig ist, durch das Hinzuschalten eines Widerstands verstimmt wird, wodurch der Stromspiegel mit einer Temperaturabhängigkeit beaufschlagt wird. Insgesamt kann durch die Sourcedegenerations-Schaltung eine Kompensation der Temperaturabhängigkeiten erreicht werden. Ferner können durch diese Maßnahme eventuell weitere Stromspiegel eingespart werden, die wie vorstehend beschrieben der Erzeugung von weiteren Teilströmen dienen. Durch die Einsparung der weiteren Teilströme wird die Leistungsaufnahme des Oszillator-Schaltkreises reduziert.

Vorteilhafterweise enthält der erste Schaltungszweig einen ersten MOS-Transistor als steuerbare Aufintegrations-Stromquelle, einen zweiten MOS-Transistor zum An- bzw. Ausschalten des Aufintegrationsvorgangs und den Ladungsspeicher.

Die genannten Bauelemente sind in dem ersten Schaltungszweig in Reihe geschaltet.

Eine weitere vorteilhafte Ausgestaltung sieht vor, dass in dem zweiten Schaltungszweig der Komparator einen dritten MOS-Transistor aufweist, dessen Gate-Anschluss mit dem Ladungsspeicher verbunden ist. Ferner ist der Komparator mit dem zweiten Widerstand in Reihe geschaltet. Über den zweiten Widerstand fällt eine Differenzspannung ab, die sich aus der Differenz zwischen der oberen und der unteren Komparatorschwelle ergibt.

Des Weiteren ist es vorteilhaft, die steuerbare Abintegrations-Stromquelle mit einem Bipolartransistor oder mit einem vierten MOS-Transistor zu realisieren und einen fünften MOS-Transistor zum An- bzw. Ausschalten des Abintegrationsvorgangs vorzusehen. Der Bipolartransistor bzw. der vierte MOS-Transistor und der fünfte MOS-Transistor sind zusammen mit dem Ladungsspeicher seriell angeordnet.

In einer weiteren, vorteilhaften Ausgestaltung der Erfindung ist der Ladungsspeicher zumindest teilweise als Gateoxid-Kapazität ausgebildet. Eine Gateoxid-Kapazität weist einen besonders geringen Chipflächenbedarf auf.

Eine weitere, besonders vorteilhafte Ausgestaltung der Erfindung sieht vor, dass ein sechster MOS-Transistor und der dritte MOS-Transistor über ihre Drain-Source-Strecken in Reihe geschaltet sind. Durch diese Schaltungsanordnung wird zu der Hauptzeitkonstante, durch welche die Oszillatorfrequenz ohne den sechsten MOS-Transistor bestimmt wäre, eine zweite Zeitkonstante hinzuaddiert. Die zweite Zeitkonstante kann einen von der Hauptzeitkonstante abweichenden Temperaturkoeffizienten aufweisen und dadurch zu einer Kompensation der Temperaturabhängigkeit des Oszillator-Schaltkreises beitragen. Ferner wird durch den sechsten MOS-Transistor, der insbesondere den gleichen Leitfähigkeitstyp wie der dritte MOS-Transistor aufweist, eine bessere Betriebsspannungsunterdrückung erzielt, da sich beide MOS-Transistoren auf die gleiche Versorgungslinie beziehen. Vorteilhafterweise ist der sechste MOS-Transistor als Diode beschaltet.

Der erste und der zweite Widerstand können vorteilhafterweise derart ausgelegt werden, dass sie niedrige Streuungen ihres Temperaturkoeffizienten und/oder niedrige Streuungen ihres Absolutwertes aufweisen. Dabei zieht eine niedrige Streuung des Temperaturkoeffizienten einen geringen Temperaturkoeffizienten der Oszillatorfrequenz nach sich und ist vorteilhaft bei der Implementierung des erfindungsgemäßen Oszillator-Schaltkreises in einen Telekommunikationschip. Demgegenüber ist bei einer Verwendung des Oszillator-Schaltkreises für Sensoren der Absolutwert der Oszillatorfrequenz wichtiger als die Temperaturabhängigkeit der Oszillatorfrequenz. Daher ist es bei der Implementierung des Oszillator-Schaltkreises in einen Sensor vorteilhaft, für die beiden Widerstände einen Widerstandstyp mit einer nur geringen Streuung seines Absolutwerts zu verwenden.

Vorteilhafterweise weisen sämtliche Widerstände des Oszillator-Schaltkreises im Wesentlichen die gleichen Temperaturkoeffizienten auf und sind insbesondere vom gleichen Widerstandstyp. Dadurch wird eine optimale Stabilität der Oszillatorfrequenz gegenüber Temperaturschwankungen gewährleistet.

Der erfindungsgemäße Oszillator-Schaltkreis eignet sich in vorteilhafter Weise für die Implementierung in einen integrierten Schaltkreis. Vorteilhafterweise lässt sich der integrierte Schaltkreis mit dem Oszillator-Schaltkreis durch CMOS (complementary metal oxid semiconductor)-Technologie herstellen.

Die Erfindung wird nachfolgend anhand von Ausführungsbeispielen unter Bezugnahme auf die Zeichnungen näher erläutert. Es zeigen:

Fig. 1    ein Schaltbild eines ersten Ausführungsbeispiels des erfindungsgemäßen temperaturstabilisierten Oszillator-Schaltkreises; und

Fig. 2    ein Schaltbild eines zweiten Ausführungsbeispiels des erfindungsgemäßen temperaturstabilisierten Oszillator-Schaltkreises.

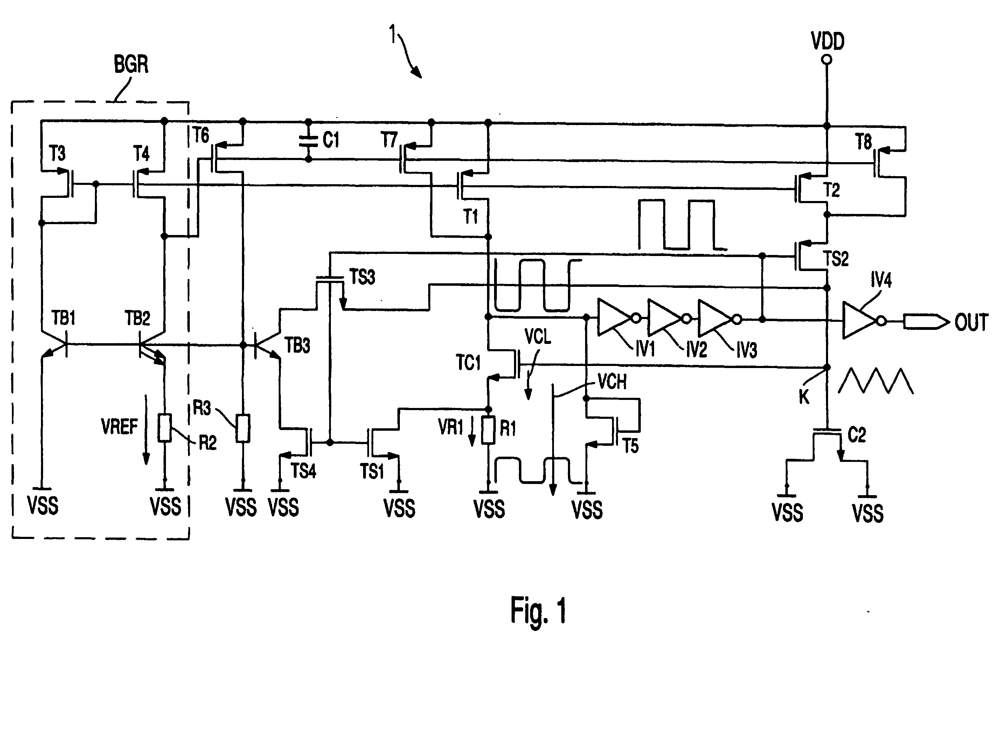

In Fig. 1 ist als erstes Ausführungsbeispiel der Erfindung ein Schaltbild eines temperaturstabilisierten Oszillator-Schaltkreises 1 dargestellt. Der Oszillator-Schaltkreis 1 weist einen Ladungsspeicher C2 auf, welcher zum einen mit einem gemeinsamen festen Potential, insbesondere einer Masse VSS, und zum anderen mit einem Knoten K verbunden ist. An den Knoten K ist ferner der Gate-Anschluss eines MOS-Transistors TC1 geschaltet. Der Knoten K kann von einem Aufintegrations-Schaltungszweig gespeist werden, welcher den Knoten K über die Drain-Source-Strecken von MOS-Transistoren TS2 und T2 mit einer Versorgungsspannung VDD verbindet. Ein weiterer Schaltungszweig, der durch die Drain-Source-Strecke eines MOS-Transistors TS3, die Kollektor-Emitter-Strecke eines Bipolartransistors TB3 sowie die Drain-Source-Strecke eines MOS-Transistors TS4 gebildet ist, dient zur Stromentnahme aus dem Knoten K. Dieser Schaltungszweig führt den entnommenen Strom gegen die Masse VSS ab.
Die Drain-Source-Strecke des MOS-Transistors TC1 ist durch einen Komparator/Referenzspannungs-Schaltungszweig zum einen über einen Widerstand R1 mit der Masse VSS verbunden und zum anderen über die Drain-Source-Strecke eines MOS-Transistors T1 mit der Versorgungsspannung VDD verbunden. Parallel zu dem Widerstand R1 ist ein MOS-Transistor TS1 angeordnet. An die Verbindungsstrecke der MOS-Transistoren T1 und TC1 ist der Drain-Anschluss eines MOS-Transistors T5 geschaltet. Der Gate-Anschluss des MOS-Transistors T5 ist mit seinem Drain-Anschluss verbunden, und der Source-Anschluss des MOS-Transistors T5 ist mit der Masse VSS beaufschlagt. Zwischen die MOS-Transistoren T1 und TC1 ist ferner der Eingang eines invertierenden Verstärkers IV1 geschaltet. Dem invertierenden Verstärker IV1 sind invertierende Verstärker IV2, IV3 und IV4 seriell nachgeschaltet. Der Ausgang des invertierenden Verstärkers IV3 ist mit den Gate-Anschlüssen der MOS-Transistoren TS1, TS2, TS3 und TS4 verbunden. Der Ausgang des invertierenden Verstärkers IV4 ist der Ausgang OUT des Oszillator-Schaltkreises 1.
Der Oszillator-Schaltkreis 1 enthält eine Bandabstands-Referenzschaltung BGR, welche aus MOS-Transistoren T3 und T4, Bipolartransistoren TB1 und TB2 sowie einem Widerstand R2 gebildet ist. Die Gate-Anschlüsse der MOS-Transistoren T3 und T4 sowie die Basis-Anschlüsse der Bipolartransistoren TB1 und TB2 sind jeweils miteinander verbunden. Die Drain-Source-Strecke des MOS-Transistors T3 bzw. T4 ist zum einen mit der Versorgungsspannung VDD beaufschlagt und zum anderen mit dem Kollektor-Anschluss des Bipolartransistors TB1 bzw. TB2 verbunden. Des Weiteren ist der Drain-Anschluss des MOS-Transistors T3 mit seinem Gate-Anschluss verbunden. Der Emitter-Anschluss des Bipolartransistors TB1 ist mit der Masse VSS beaufschlagt. Zwischen dem Emitter-Anschluss des Bipolartransistors TB2 und der Masse VSS ist der Widerstand R2 angeordnet.
Der MOS-Transistor T3 stellt den Eingangstransistor einer Stromquellenbank dar, welche zur Stromgenerierung in den Drain-Source-Strecken der MOS-Transistoren T1, T2 und T4 dient. Dazu ist der Gate-Anschluss des MOS-Transistors T3 an die Gate-Anschlüsse der MOS-Transistoren T1, T2 und T4 gekoppelt.
Ein MOS-Transistor T6 ist mit einem Widerstand R3 seriell zwischen die Versorgungsspannung VDD und die Masse VSS geschaltet. Der Gate-Anschluss des MOS-Transistors T6 ist mit dem Drain-Anschluss des MOS-Transistors T4 verbunden. Ferner ist der Gate-Anschluss des MOS-Transistors T6 mit den Gate-Anschlüssen von MOS-Transistoren T7 und T8 verbunden. Die Source-Anschlüsse der MOS-Transistoren T6, T7 und T8 sind mit der Versorgungsspannung VDD beaufschlagt. Der Drain-Anschluss des MOS-Transistors T7 ist an den Drain-Anschluss des MOS-Transistors T1 geschaltet. Der Drain-Anschluss des MOS-Transistors T8 ist an den Drain-Anschluss des MOS-Transistors T2 geschaltet. Zwischen dem Gate-Anschluss des MOS-Transistors T6 und der Versorgungsspannung VDD ist ein Kondensator C1 angeordnet.
Die Basis-Anschlüsse der Bipolartransistoren TB1 und TB2 sind an die Verbindungsstrecke zwischen dem MOS-Transistor T6 und dem Widerstand R3 geschaltet sowie mit dem Basis-Anschluss des Bipolartransistors TB3 verbunden.
Bei dem vorliegenden Oszillator-Schaltkreis 1 sind die MOS-Transistoren TC1, TS1, TS3, TS4 und T5 n-Kanal-MOSFETs. Die MOS-Transistoren TS2, T1, T2, T3, T4, T6, T7 und T8 sind durch p-Kanal-MOSFETs realisiert. Die Bipolartransistoren TB1, TB2 und TB3 sind als npn-Transistoren ausgelegt.
Die Funktion des Oszillator-Schaltkreises 1 ist es, den Ladungsspeicher C2 zyklisch zu laden und zu entladen. Der durch die MOS-Transistoren T2 und TS2 gebildete Aufintegrations-Schaltungszweig dient dabei zum Laden des Ladungsspeichers C2. Der MOS-Transistor T2 stellt eine Aufintegrations-Stromquelle dar. Der Stromfluss von dem MOS-Transistor T2 in den Ladungsspeicher C2 lässt sich durch den MOS-Transistor TS2 schalten. Zum Entladen des Ladungsspeichers C2 wird der durch den Bipolartransistor TB3 sowie die MOS-Transistoren TS3 und TS4 gebildete Schaltungszweig verwendet. Der Bipolartransistor TB3 ist hierbei eine Abintegrations-Stromquelle, welche durch die MOS-Transistoren TS3 bzw. TS4 mit dem Ladungsspeicher C2 bzw. mit der Masse VSS verbindbar ist. Die Auf- und Abintegrations-Stromquellen sind, um einen referenzierten Strom zu erhalten, mit ihren Steueranschlüssen jeweils an die Bandabstands-Referenzschaltung BGR angeschlossen.
Zum Umschalten zwischen dem Laden und Entladen des Ladungsspeichers C2 dient ein Komparator in der Form des MOS-Transistors TC1, welcher mit seinem Gate-Anschluss den Ladungszustand des Ladungsspeichers C2 detektiert. Die Bandabstands-Referenzschaltung BGR erzeugt über dem Widerstand R2 eine Referenzspannung VREF, welche mittels des die MOS-Transistoren T3 und T1 umfassenden Stromspiegels derart gespiegelt wird, dass eine zu der Referenzspannung VREF proportionale Spannung VR1 über dem Widerstand R1 abfällt. Die Spannung VR1 ist die Differenz aus einer oberen Komparatorschwellenspannung VCH und einer unteren Komparatorschwellenspannung VCL. Die untere Komparatorschwellenspannung VCL berechnet sich dabei aus der Summe von der Schwellspannung des MOS-Transistors TC1 und der effektiven Gate-Source-Spannung des MOS-Transistors TC1. Die obere Komparatorschwellenspannung VCH berechnet sich aus der Summe von der unteren Komparatorschwellenspannung VCL und der Spannung VR1.

Die invertierenden Verstärker IV1, IV2 und IV3 steuern die MOS-Transistoren TS2 und TS3, welche zum An- bzw. Ausschalten des Lade- oder Entladevorgangs bestimmt sind. Die Abintegration von dem Ladungsspeicher C2 erfolgt nach Erreichen der oberen Komparatorschwellenspannung VCH, während die Aufintegration auf den Ladungsspeicher C2 nach Erreichen der unteren Komparatorschwellenspannung VCL erfolgt. Über dem Ladungsspeicher C2 bildet sich dabei eine Dreiecksspannung. Die Frequenz dieser Oszillator-Dreiecksspannung beträgt $1/(2 \cdot R1 \cdot C2)$, wobei R1 den Widerstandswert des Widerstands R1 angibt und C2 die Kapazität des Ladungsspeichers C2.

Über die invertierenden Verstärker IV1, IV2 und IV3 werden ferner die MOS-Transistoren TS1 und TS4 gesteuert. Dabei schaltet der MOS-Transistor TS1 bei der Abintegration von dem Ladungsspeicher C2 den Widerstand R1 kurz. Durch den MOS-Transistor TS4 werden während der Abintegration von dem Ladungsspeicher C2 die Basisströme der Bipolartransistoren TB1 und TB2 verringert.

An dem Ausgang OUT des invertierenden Verstärkers IV4 ist ein verstärktes Signal abgreifbar, welches die Oszillatorfrequenz wiedergibt.

In dem vorliegenden ersten Ausführungsbeispiel der Erfindung ist der Ladungsspeicher C2 durch eine Gateoxid-Kapazität realisiert, die vorzugsweise vertikal wie der MOS-Transistor TC1 aufgebaut ist.

Die für den Betrieb des Ladungsspeichers C2 erforderliche Vorspannung ist gleich der Summe aus der Schwellspannung des MOS-Transistors TC1 und einigen 100 mV. Dadurch dass die untere Komparatorschwellenspannung VCL gleich der Summe aus der Schwellspannung und der effektiven Gate-Source-Spannung des MOS-Transistors TC1 ist, ist die angegebene Vorspannung für den Ladungsspeicher C2 stets gewährleistet.

Der aus den MOS-Transistoren T1 und TC1 sowie dem Widerstand R1 gebildete Komparator/Referenzspannungs-Schaltungszweig erfüllt gleichzeitig drei Erfordernisse. So dient dieser Schaltungszweig zur Realisierung der Komparatorschwellenspannungen VCL und VCH, zur Realisierung der Komparatorfunktion sowie zur Erzeugung der für den Ladungsspeicher C2 erforderlichen Vorspannung.

In dem vorliegenden ersten Ausführungsbeispiel erfolgt die Temperaturstabilisierung der Oszillatorfrequenz durch die Addition geeigneter Ströme. Dabei werden jeweils zwei Ströme einander überlagert, die unterschiedliche oder gar gegenläufige Temperaturabhängigkeiten bzw. Temperaturkoeffizienten aufweisen. Die überlagerten Ströme können statisch fließen oder mit dem Oszillatortakt geschaltet werden. Insgesamt resultiert daraus ein Kompensation von Temperaturabhängigkeiten, sodass die Oszillatorfrequenz einen vorgegebenen Temperaturkoeffizienten oder einen im Wesentlichen temperaturunabhängigen Wert annimmt.

Der Widerstand R1 geht direkt in den Wert der Oszillatorfrequenz ein und weist gemäß Gleichung (1) eine Temperaturabhängigkeit auf, die mittels der Erfindung kompensiert werden soll:

$$R1 = R10 \cdot (1 + a \cdot (T - T0) + b \cdot (T - T0)^2), \hspace{3cm} (1)$$

wobei T die Temperatur, a den Temperaturkoeffizienten, der den linearen Temperaturterm betrifft, und b den quadratischen Temperaturkoeffizienten angeben. R10 steht für den Widerstandswert des Widerstands R1 bei einer Bezugstemperatur T0 von beispielsweise 25°C.

In dem Oszillator-Schaltkreis 1 wird die durch Gleichung (1) beschriebene Temperaturabhängigkeit des Widerstands R1 durch die Addition der Ströme, die durch die MOS-Transistoren T1 und T7 generiert werden, kompensiert. Der durch den MOS-Transistor T1 fließende Strom wird in der Bandabstands-Referenzschaltung BGR erzeugt und durch den MOS-Transistor T3 in den MOS-Transistor T1 gespiegelt. Der durch den MOS-Transistor T3 fließende Strom ist proportional zu einer PTAT (proportional to absolute temperature)-Spannung, welche proportional zur Temperatur in Kelvin ist. Dieses entspricht einem positiven Temperaturkoeffizienten. Da ein Stromspiegel selbst im idealen Fall keine Temperaturabhängigkeit aufweist, ist auch der Strom durch den MOS-Transistor T1 proportional zu einer PTAT-Spannung. Demgegenüber wird der Strom durch den MOS-Transistor T7 durch eine Spiegelung des durch den MOS-Transistor T6 fließenden Stroms erzeugt. Der Strom, der durch den MOS-Transistor T6 fließt, ist aufgrund der Anordnung des Bipolartransistors TB2 proportional zu einer Basis-Emitter-Spannung. Somit gilt das Gleiche auch für den MOS-Transistor T7, und dieser weist demnach einen negativen Temperaturkoeffizienten auf.

Insgesamt ergibt sich daraus eine Überlagerung von zwei Strömen, die durch den Widerstand R1 fließen und deren Temperaturkoeffizienten mit unterschiedlichen Vorzeichen behaftet sind. Für die über den Widerstand R1 abfallende Spannung VR1 folgt damit aus den bekannten Bandabstandsgleichungen:

$$VR1 = k1 \cdot (T/T0) - k2 \cdot (1 - (VG0 - VBE0)/VG0) \cdot (T/T0), \tag{2}$$

wobei k1 und k2 für Stromspiegelverhältnisse stehen, und VG0 bzw. VBE0 Gate- bzw. Basis-Emitter-Spannungen angeben. Der erste Summand in Gleichung (2) steigt mit der Temperatur, während der zweite Summand bei steigender Temperatur fällt. Da k1 und k2 lediglich Stromspiegelverhältnisse sind, kann technologieunabhängig eine Korrekturspannung über dem Widerstand R1 erzeugt werden. Die derart korrigierte Spannung kann auf den gleichen Temperaturkoeffizienten wie der Widerstand R1 eingestellt werden.

Die Gateoxid-Kapazität des Ladungsspeichers C2 beeinflusst wegen ihres verhältnismäßig kleinen Temperaturkoeffizienten die Oszillatorfrequenz nur sehr wenig.

Ferner ist erfindungsgemäß vorgesehen, dass die Widerstände R1 und R2 sowie vorzugsweise auch der Widerstand R3 gleiche Temperaturkoeffizienten und vorzugsweise auch gleiche Widerstandswerte aufweisen. Insbesondere bei der Implementierung des Oszillator-Schaltkreises 1 in einen Telekommunikationschip ist es vorteilhaft, wenn für die Widerstände R1, R2 und R3 ein Widerstandstyp mit einer nur geringen technologischen Streuung seines Temperaturkoeffizienten verwendet wird. Dadurch ergibt sich eine optimale Temperaturstabilität der Oszillatorfrequenz, und es entfällt eine technologische Streuung, die durch die Verwendung unterschiedlicher Widerstände verursacht würde.

Im Vergleich dazu besitzen bekannte Oszillator-Schaltkreise, bei denen versucht wird, eine Temperaturstabilität durch Mischungsverhältnisse von Widerständen zu erzielen, eine grundsätzliche Temperaturabhängigkeit, die durch technologische Widerstandsstreuungen verursacht wird. Für zwei Widerstände R1 und R2 mit den Temperaturkoeffizienten a1 bzw. a2 beträgt diese Abhängigkeit des Temperaturkoeffizienten ca. $(a1 - a2) \cdot R1/(R1 + R2)$. Das bedeutet, dass bei einem Unterschied der beiden Temperaturkoeffizienten a1 und a2 von beispielsweise 3000 ppm/K und bei ähnlich großen Widerstandswerten der Widerstände R1 und R2 durch 20% Schichtwiderstandsänderung der Temperaturkoeffizient sich bereits um 250 ppm/K ändert.

Die vorstehend beschriebene Maßnahme zur Kompensation der Temperaturabhängigkeit des Komparator/Referenzspannungs-Schaltungszweigs wird in dem vorliegenden ersten Ausführungsbeispiel der Erfindung in analoger Weise auch für den Aufintegrations-Schaltungszweig verwendet. Dazu wird entsprechend dem MOS-Transistor T7 der MOS-Transistor T8 verwendet, der ebenfalls von einem von dem MOS-Transistor T6 gespiegelten Strom durchflossen wird und dadurch auch eine Proportionalität zu der Basis-Emitter-Spannung aufweist. Der durch den MOS-Transistor T2 fließende Strom ist wiederum proportional zu einer PTAT-Spannung, sodass sich in gleicher Weise wie zuvor beschrieben eine Temperaturkompensation ergibt.

Bei Strömen, die proportional zu einer Basis-Emitter-Spannung sind, sind nach den Bandabstandsgleichungen die nichtlinearen Anteile durch den Term $((n - 1 + a) \cdot k \cdot T/q \cdot \ln(T/T0))/VG0$ gegeben, wobei n für einen Technologieparameter steht. Die nichtlinearen Anteile eines PTAT-Stroms sind im Wesentlichen durch den Term $1 + b$ gegeben. Durch das Zumischen von Strömen durch die MOS-Transistoren T7 und T8 werden die nichtlinearen Anteile vergrößert oder verkleinert, wodurch sich die Möglichkeit einer Kompensation des quadratischen Anteils des Widerstands R1 ergibt.

Um die vorstehend beschriebene Temperaturkompensation reproduzierbar zu machen und nicht durch Matchingfehler in den Stromspiegeln Fehler der Temperaturkoeffizienten zu verursachen, ist es vorteilhaft, die jeweiligen Transistoren innerhalb eines Stromspiegels durch dynamischen Elementeaustausch zu kompensieren.

In dem in Fig. 1 gezeigten ersten Ausführungsbeispiel der Erfindung ist in eine weitere Möglichkeit zur Temperaturkompensation aufgezeigt, welche eventuell auch unabhängig von dem Zumischen von Strömen durch die MOS-Transistoren T7 und T8 realisiert werden kann. Diese Möglichkeit ergibt sich durch die Anordnung des MOS-Transistors T5 am Drain-Anschluss des MOS-Transistors TC1. Dadurch wird die Polfrequenz am Ausgang des Komparators heraufgesetzt und gleichzeitig eine zweite sehr kurze und gut definierte Zeitkonstante erzeugt, die neben der aus dem Term $2 \cdot R1 \cdot C2$ gebildeten Hauptzeitkonstante zu der Oszillatorfrequenz beiträgt.

Die durch den MOS-Transistor T5 erzeugte zweite Zeitkonstante wird durch die Steilheit gm des Transistors T5 bestimmt. Die Steilheit gm ist durch Gleichungen (3) und (4) gegeben:

$$gm = \sqrt{2 \cdot \beta \cdot I_D} \tag{3}$$

$$\beta = \mu \cdot C_{ox} \cdot \frac{W}{L} \tag{4}$$

In den Gleichungen (3) und (4) beziehen sich alle Parameter auf den MOS-Transistor T5. Im Einzelnen stehen $\beta$ für den Steilheitskoeffizienten, $I_D$ für den Drain-Strom, W bzw. L für die Kanalbreite bzw. -länge, $\mu$ für die Beweglichkeit der Ladungsträger im Kanal und $C_{ox}$ für die Kapazität des Gateoxids des MOS-Transistors T5.

Die Temperaturkoeffizienten der Beweglichkeit $\mu$ bzw. des Drain-Stroms $I_D$ betragen beispielsweise -5000 ppm/K bzw. 3000 ppm/K. Daraus ergibt sich für den Temperaturkoeffizienten der Steilheit gm ein Wert von etwa -1000 ppm/K, wohingegen der Widerstand R1 einen Temperaturkoeffizienten von 200 ppm/K aufweisen kann. Daraus wird ersichtlich, dass eine Summenbildung der Hauptzeitkonstante mit der zweiten Zeitkonstante eine Kompensation der Temperaturabhängigkeit der Gesamtzeitkonstante und damit der Oszillatorfrequenz möglich macht.

Ein weiterer Vorteil des MOS-Transistors T5 ist, dass durch seine Anordnung an dem Drain-Anschluss des MOS-Transistors TC1 der Spannungshub am Ausgang des Komparators definiert wird.

Beide MOS-Transistoren TC1 und T5 besitzen vorzugsweise den gleichen Leitfähigkeitstyp und beziehen sich auf die gleiche Versorgungslinie. Diese Maßnahmen haben zum Vorteil, dass dadurch die Potentiale am Eingang und am Ausgang des Komparators unabhängig von der Versorgungsspannung VDD sind.

Eine weitere Möglichkeit, um die Temperaturabhängigkeiten zu kompensieren, ist durch eine Sourcedegenerations-Schaltung gegeben. Dabei werden beispielsweise an die Drain-Anschlüsse der MOS-Transistoren T1 und/oder T2 Widerstände geschaltet, welche die gleichen Widerstandswerte wie die Widerstände R1 und R2 aufweisen. Durch diese Widerstände werden die aus den MOS-Transistoren T3 und T1 bzw. T3 und T2 gebildeten Stromspiegel verstimmt. Grundsätzlich weisen Stromspiegel ein temperaturunabhängiges Verhalten auf. Durch die Verstimmung der Stromspiegel werden den genannten Stromspiegeln jedoch Temperaturkoeffizienten aufgeprägt, die zur Kompensation anderer Temperaturkoeffizienten verwendet werden können. Vorteilhaft an dieser Maßnahme ist, dass die MOS-Transistoren T7 und T8 eingespart werden können, wodurch die Leistungsaufnahme des Oszillator-Schaltkreises 1 reduziert wird.

Der Ausgangsstrom IOUT eines mit einer Sourcedegenerations-Schaltung verstimmten Stromspiegels ist durch Gleichungen (5) und (6) gegeben:

$$IOUT = \frac{IIN}{1 + \sqrt{2 \cdot \beta(T) \cdot R_{SD}(T)^2 \cdot IIN}} \tag{5}$$

$$\beta(T) = \mu(T) \cdot C_{ox} \cdot \frac{W}{L} \tag{6}$$

IIN gibt in Gleichung (5) den Eingangsstrom des Stromspiegels an, und $R_{SD}$ steht für den am Ausgang des Stromspiegels angeordneten Widerstand. Die übrigen Parameter sind in analoger Weise zu Gleichung (4) definiert.

Für die temperaturabhängige Oszillatorfrequenz f(T) folgt daraus:

$$\frac{1}{f(T)} = 2 \cdot R1(T) \cdot C2 \cdot \left(1 + \sqrt{\frac{1}{2} \cdot \beta(T) \cdot \frac{R_{SD0}}{R_{30}} \cdot R_{SD}(T) \cdot \Delta U_{BE}(T)}\right) \tag{7}$$

Dabei sind die Beweglichkeit $\mu(T)$ und der Steilheitskoeffizient $\beta(T)$ sehr gut definierte Parameter mit einem Fehler von jeweils typischerweise $\pm$ 5%. Sofern der Temperaturkoeffizient des verwendeten Widerstandstyps klein genug ist, ist die Temperaturkompensation unempfindlich gegenüber Schwankungen in den Absolutwerten der Widerstände.

In einer alternativen Ausführungsform der vorliegenden Erfindung können die Bipolartransistoren TB1, TB2 und TB3 durch MOS-Transistoren, welche im Weak-Inversion-Bereich betrieben werden, ersetzt werden.

Die MOS-Transistoren TS1, TS2, TS3 und TS4 können auch durch andere Schalter gebildet sein.

Anstelle der invertierenden Verstärker IV1, IV2, IV3 und IV4 können digitale Gatter vorgesehen sein.

Durch die MOS-Transistoren T1 und T2 fließt jeweils ein gespiegelter PTAT-Strom, welcher in der Bandabstands-Referenzschaltung BGR generiert wird. Dadurch wird ein in der Bandabstands-Referenzschaltung BGR erzeugtes Rauschen auch diesen Strömen überlagert. Ein durch Rauschen erhöhter Strom durch den MOS-Transistor T1 erhöht sowohl die untere Komparatorschwellenspannung VCL als auch die obere Komparatorschwellenspannung VCH. Bei einem ebenfalls durch Rauschen erhöhten Strom durch den Aufintegrations-Schaltungszweig bleibt die Oszillatorfrequenz unbeeinflusst. Jedoch erhöhen sich die beiden Komparatorschwellenspannungen VCL und VCH nur bei tieffrequentem Rauschen in gleichem Maße. Das bedeutet, dass niederfrequentes 1/f-Rauschen zu keiner Erhöhung des Frequenzjitters führt.

Das in Fig. 1 gezeigte erste Ausführungsbeispiel der Erfindung weist in keinem Schaltungszweig zwischen der Versorgungsspannung VDD und der Masse VSS mehr als eine Schwellspannung eines MOS-Transistors oder mehr als eine Basis-Emitter-Spannung eines Bipolartransistors in Serie auf. Daher ist das vorliegende Ausführungsbeispiel für sehr geringe Versorgungsspannungen VDD geeignet. Dadurch dass der Komparator/Referenzspannungs-Schaltungszweig gemeinsam für den Komparator, die Erzeugung der Komparatorschwellenspannungen VCL und VCH sowie die Vorspannungserzeugung für den Ladungsspeicher C2 ausgelegt ist, ist der Oszillator-Schaltkreises 1 wegen der daraus resultierenden sehr geringen Stromaufnahme für die Generierung eines Arbeitstaktes während des Bereitschaftsbetriebs besonders gut geeignet. Zudem weist der Oszillator-Schaltkreis 1 einen geringen Chipflächenbedarf auf.

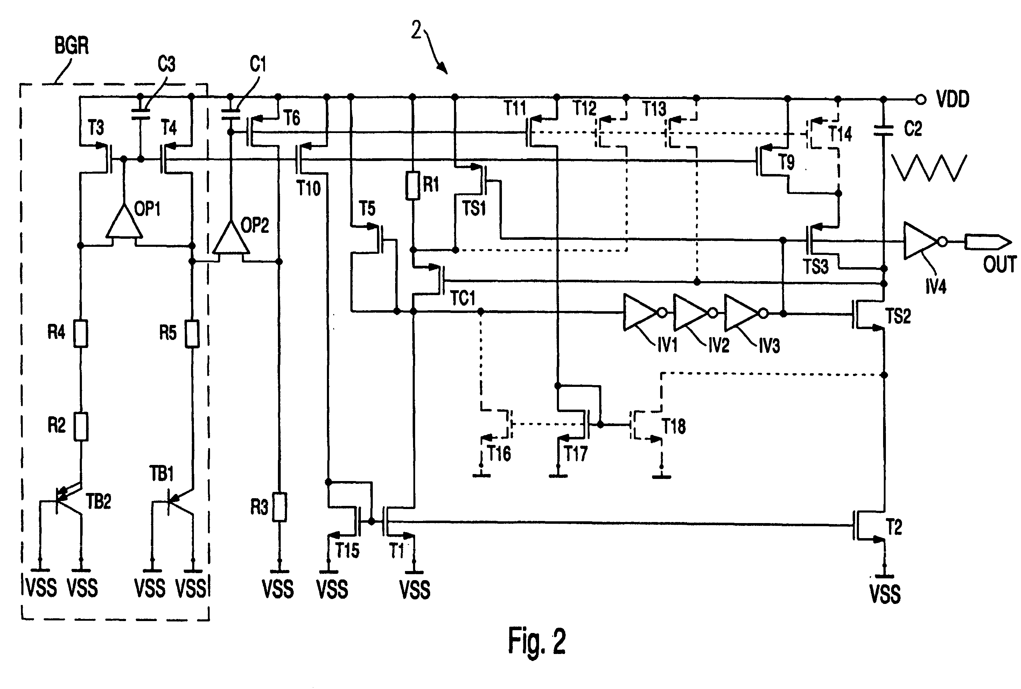

In Fig. 2 ist als zweites Ausführungsbeispiel der Erfindung ein Schaltbild eines temperaturstabilisierten Oszillator-Schaltkreises 2 dargestellt. Der Oszillator-Schaltkreis 2 entspricht in vielen Schaltungsteilen dem in Fig. 1 gezeigten Oszillator-Schaltkreis 1. Daher sind die gleichen oder vergleichbare Funktionselemente mit den gleichen Bezugszeichen versehen.

In dem Oszillator-Schaltkreis 2 ist der Ladungsspeicher C2 ein Kondensator, dessen einer Anschluss mit der Versorgungsspannung VDD anstelle der Masse VSS beaufschlagt ist. Entsprechend sind die Bezugspotentiale der übrigen Bauelemente im Oszillator-Schaltkreis 2 im Vergleich zum Oszillator-Schaltkreis 1 abgeändert.

Die Abintegrations-Stromquelle ist im Oszillator-Schaltkreis 2 durch einen MOS-Transistor T9 mit einem p-dotierten Kanal realisiert. Ferner weist der Oszillator-Schaltkreis 2 Operationsverstärker OP1 bzw. OP2 zur Beaufschlagung der Gate-Potentiale der MOS-Transistoren T3 und T4 bzw. T6 auf.

Der Oszillator-Schaltkreis 2 enthält MOS-Transistoren T10, T11, T12, T13 und T14, deren Kanal p-dotiert ist, und MOS-Transistoren T15, T16, T17 und T18, deren Kanal n-dotiert ist. Einige dieser MOS-Transistoren sowie einige ihrer Verbindungslinien zu den anderen Bauelementen sind mit gestrichelten Linien in Fig. 2 eingezeichnet. Dieses zeigt an, dass die betreffenden MOS-Transistoren optional in den Oszillator-Schaltkreis 2 aufgenommen werden können oder schaltbar ausgelegt werden können.

Der durch den MOS-Transistor T6 fließende Strom weist in Fig. 2 aufgrund der Beschaltung des MOS-Transistors T6 eine Proportionalität mit einer CTAT (complementary to absolute temperature)-Spannung auf. Demnach ist der Temperaturkoeffizient dieses Stroms negativ. Durch Stromspiegelanordnungen wird er in die MOS-Transistoren T11, T12, T13 und T14 gespiegelt. Aufgrund der grundsätzlichen Temperaturunabhängigkeit eines Stromspiegels weisen auch die durch die genannten MOS-Transistoren fließenden Ströme ein zur Temperatur gegenläufiges Verhalten auf.

Die durch die MOS-Transistoren T3 und T4 fließenden Ströme sind proportional zu einer PTAT-Spannung. Durch Stromspiegelung wird beispielsweise auch in dem MOS-Transistor T10 ein Strom erzeugt, welcher sich proportional zu der Temperatur verhält.

Durch die in Fig. 2 gestrichelt eingezeichneten MOS-Transistoren können Differenzen bzw. Summen mit bereits bestehenden Strömen gebildet werden, wodurch Temperaturabhängigkeiten kompensiert werden. Im Einzelnen dient der MOS-Transistor T12 zur Differenzbildung mit dem durch den MOS-Transistor T1 erzeugten Strom im Komparator/Referenzspannungs-Schaltungszweig. Die MOS-Transistoren T13 und T14 erzeugen jeweils Ströme, die von dem durch den MOS-Transistor T2 erzeugten Strom im Aufintegrations-Schaltungszweig subtrahiert werden. Die von den MOS-Transistoren T16 bzw. T18 generierten Ströme bilden jeweils eine Summe mit den von den MOS-Transistoren T1 bzw. T2 generierten Strömen im Komparator/Referenzspannungs- bzw. Aufintegrations-Schaltungszweig.

**Patentansprüche**

**1.** Temperaturstabilisierter Oszillator-Schaltkreis (1, 2), welcher auf zyklischem Laden und Entladen eines Ladungsspeichers (C2) basiert, mit

- einem Ladungsspeicher (C2),
- einer steuerbaren Aufintegrations-Stromquelle (T2) zum Laden des Ladungsspeichers (C2),
- einer steuerbaren Abintegrations-Stromquelle (TB3, T9) zum Entladen des Ladungsspeichers (C2),
- einem ersten Widerstand (R2), über dem eine Referenzspannung (VREF) abfällt,
- einem zweiten Widerstand (R1), über welchem eine Spannung abfällt, die proportional zu der Referenzspannung (VREF) ist, wobei die beiden Widerstände (R1, R2) im Wesentlichen die gleichen Temperaturkoeffizienten aufweisen,
- einem Komparator (TC1) zur Steuerung der Aufintegrations-Stromquelle (T2) und der Abintegrations-Stromquelle (TB3, T9) in Abhängigkeit von dem Ladezustand des Ladungsspeichers (C2), einer vorgegebenen unteren Komparatorschwelle (VCL) und einer vorgegebenen oberen Komparatorschwelle (VCH),
- einem ersten Schaltungszweig, der die steuerbare Aufintegrations-Stromquelle (T2) oder die steuerbare Abintegrations-Stromquelle (TB3, T9) enthält, und
- einem zweiten Schaltungszweig, der den Komparator (TC1) enthält und/oder zur Erzeugung der beiden Komparatorschwellen (VCL, VCH) dient,

**dadurch gekennzeichnet,**

- **dass** eine Bandabstands-Referenzschaltung (BGR) zur Erzeugung der Referenzspannung (VREF) vorgesehen ist,
- **dass** der erste Widerstand (R2) in der Bandabstands-Referenzschaltung (BGR) enthalten ist,
- **dass** der erste Schaltungszweig und/oder der zweite Schaltungszweig zumindest zeitweise jeweils zwei einander überlagerte Teilströme mit unterschiedlichen Temperaturabhängigkeiten aufweisen, wobei
- der erste Schaltungszweig und der zweite Schaltungszweig und insbesondere mindestens ein weiterer Schaltungszweig des Oszillator-Schaltkreises (1, 2) jeweils zumindest zeitweise eine Summe oder eine Differenz von jeweils zwei überlagerten Teilströmen mit unterschiedlichen Temperaturabhängigkeiten aufweisen, und
- die Teilströme derart einstellbar oder eingestellt sind, dass lineare Terme und quadratische Terme und insbesondere Terme höherer Ordnung der Temperaturabhängigkeit der Oszillatorfrequenz im Wesentlichen minimiert sind, und
- **dass** die Teilströme insbesondere von der Bandabstands-Referenzschaltung (BGR) bestimmt werden.

2. Temperaturstabilisierter Oszillator-Schaltkreis (1, 2) nach Anspruch 1,
**dadurch gekennzeichnet,**

- **dass** der erste Widerstand (R2) und der zweite Widerstand (R1) vom gleichen Widerstandstyp sind.

3. Temperaturstabilisierter Oszillator-Schaltkreis (1, 2) nach Anspruch 1 oder 2,
**dadurch gekennzeichnet,**

- **dass** mittels der Bandabstands-Referenzschaltung (BGR) zumindest einer der Teilströme erzeugbar ist.

4. Temperaturstabilisierter Oszillator-Schaltkreis (1, 2) nach einem der Ansprüche 1 bis 3,
**dadurch gekennzeichnet,**

- **dass** die Bandabstands-Referenzschaltung (BGR) mit dem ersten und/oder mit dem zweiten Schaltungszweig über mindestens einen Stromspiegel verbunden ist.

5. Temperaturstabilisierter Oszillator-Schaltkreis (1, 2) nach Anspruch 4,
**dadurch gekennzeichnet,**

- **dass** der mindestens eine Stromspiegel zum dynamischen Bauelementeaustausch ausgelegt ist.

6. Temperaturstabilisierter Oszillator-Schaltkreis (1, 2) nach einem der vorhergehenden Ansprüche,
**gekennzeichnet durch**

- mindestens einen Stromspiegel, welcher den ersten Schaltungszweig und/oder den zweiten Schaltungszweig speist und an dessen Ausgang ein dritter Widerstand geschaltet ist, wobei der dritte Widerstand insbesondere den gleichen Temperaturkoeffizienten und/oder den gleichen Widerstandswert wie der erste und der zweite Widerstand (R2, R1) aufweist.

7. Temperaturstabilisierter Oszillator-Schaltkreis (1, 2) nach einem oder mehreren der vorhergehenden Ansprüche,
**dadurch gekennzeichnet,**

- **dass** im ersten Schaltungszweig ein erster MOS-Transistor (T2) als steuerbare Aufintegrations-Stromquelle, ein zweiter MOS-Transistor (TS2) zum An- bzw. Ausschalten des Aufintegrationsvorgangs und der Ladungsspeicher (C2) in Reihe geschaltet sind.

8. Temperaturstabilisierter Oszillator-Schaltkreis (1, 2) nach einem oder mehreren der vorhergehenden Ansprüche,
**dadurch gekennzeichnet,**

- **dass** im zweiten Schaltungszweig der Komparator in Form eines dritten MOS-Transistors (TC1), dessen Gate-Anschluss mit dem Ladungsspeicher (C2) verbunden ist, mit dem zweiten Widerstand (R1), über welchen eine Differenzspannung (VR1) abfällt, die aus der Differenz zwischen der oberen Komparatorschwelle (VCH) und der unterer Komparatorschwelle (VCL) gebildet ist, in Reihe geschaltet ist.

9. Temperaturstabilisierter Oszillator-Schaltkreis (1, 2) nach einem oder mehreren der vorhergehenden Ansprüche, **dadurch gekennzeichnet,**

- **dass** die steuerbare Abintegrations-Stromquelle in Form eines Bipolartransistors (TB3) oder eines vierten MOS-Transistors (T9), ein fünfter MOS-Transistor (TS3) zum An- bzw. Ausschalten des Abintegrationsvorgangs und der Ladungsspeicher (C2) in Reihe geschaltet sind.

10. Temperaturstabilisierter Oszillator-Schaltkreis (1, 2) nach einem oder mehreren der vorhergehenden Ansprüche, **dadurch gekennzeichnet,**

- **dass** der Ladungsspeicher zumindest teilweise als Gateoxid-Kapazität (C2) ausgebildet ist.

11. Temperaturstabilisierter Oszillator-Schaltkreis (1, 2) nach einem oder mehreren der vorhergehenden Ansprüche, **gekennzeichnet durch**

- einen sechsten MOS-Transistor (T5), der mit dem dritten MOS-Transistor (TC1) in Reihe geschaltet ist und insbesondere den gleichen Leitfähigkeitstyp wie der dritte MOS-Transistor (TC1) aufweist.

12. Temperaturstabilisierter Oszillator-Schaltkreis (1, 2) nach Anspruch 11, **dadurch gekennzeichnet,**

- **dass** der sechste MOS-Transistor (T5) als Diode beschaltet ist.

13. Temperaturstabilisierter Oszillator-Schaltkreis (1, 2) nach einem oder mehreren der vorhergehenden Ansprüche, **dadurch gekennzeichnet,**

- **dass** der erste Widerstand (R2) und der zweite Widerstand (R1) niedrige Streuungen ihres Temperaturkoeffizienten und/oder niedrige Streuungen ihres Absolutwertes aufweisen.

14. Temperaturstabilisierter Oszillator-Schaltkreis (1, 2) nach einem oder mehreren der vorhergehenden Ansprüche, **dadurch gekennzeichnet,**

- **dass** sämtliche Widerstände (R1, R2, R3, R4, R5) des Oszillator-Schaltkreises (1, 2) im Wesentlichen die gleichen Temperaturkoeffizienten aufweisen und insbesondere vom gleichen Widerstandstyp sind.

15. Temperaturstabilisierter Oszillator-Schaltkreis (1, 2) nach einem oder mehreren der vorhergehenden Ansprüche, **dadurch gekennzeichnet,**

- **dass** der Oszillator-Schaltkreis (1, 2) ein festes Substrat aufweist, auf dem die Bauelemente des Oszillator-Schaltkreises (1, 2) monolithisch integriert sind.

16. Temperaturstabilisierter Oszillator-Schaltkreis (1, 2) nach Anspruch 15, **dadurch gekennzeichnet,**

- **dass** der Oszillator-Schaltkreis (1, 2) durch CMOS-Technologie realisiert ist.


**Claims**

1. Temperature-stabilized oscillator circuit (1, 2) based on cyclic charging and discharging of a charge storage device (C2), having

- a charge storage device (C2),

- a controllable upward-integration current source (T2) for charging the charge storage device (C2),
- a controllable downward-integration current source (TB3, T9) for discharging the charge storage device (C2),
- a first resistor (R2), across which is dropped a reference voltage (VREF),
- a second resistor (R1), across which is dropped a voltage which is proportional to the reference voltage (VREF), the two resistors (R1, R2) essentially having the same temperature coefficients,
- a comparator (TC1) for controlling the upward-integration current source (T2) and the downward-integration current source (TB3, T9) in a manner dependent on the charge state of the charge storage device (C2), a predetermined lower comparator threshold (VCL) and a predetermined upper comparator threshold (VCH),
- a first circuit branch containing the controllable upward-integration current source (T2) or the controllable downward integration current source (TB3, T9),
- a second circuit branch containing the comparator (TC1) and/or serving to generate the two comparator thresholds (VCL, VCH), **characterized in that**
- a bandgap reference circuit (BGR) for generating reference voltage (VREF) is provided,
- the first resistor (R2) is contained in the bandgap reference circuit (BGR),
- the first circuit branch and/or the second circuit branch have, at least occasionally, in each case two mutually superposed partial currents with different temperature dependences,
- the first circuit branch and the second circuit branch and in particular at least one further circuit branch of the oscillator circuit (1, 2) in each case having, at least occasionally, a sum or a difference of two superposed partial currents with different temperature dependences,
- the partial currents being able to be set or being set in such a way that linear terms and quadratic terms and in particular higher-order terms of the temperature dependence of the oscillator frequency are essentially minimized, and
- that the partial currents are determined in particular by the bandgap reference circuit (BGR).

2. Temperature-stabilized oscillator circuit (1, 2) according to Claim 1, **characterized**

   - **in that** the first resistor (R2) and the second resistor (R1) are of the same type of resistor (3).

3. Temperature-stabilized oscillator circuit (1, 2) according to Claim 1 or 2, **characterized**

   - **in that** at least one of the partial currents can be generated by means of the bandgap reference circuit (BGR).

4. Temperature-stabilized oscillator circuit (1, 2) according to one of Claims 1 to 3, **characterized**

   - **in that** the bandgap reference circuit (BGR) is connected to the first and/or to the second circuit branch via at least one current mirror.

5. Temperature-stabilized oscillator circuit (1, 2) according to Claim 4, **characterized**

   - **in that** the at least one current mirror is designed for dynamic element matching.

6. Temperature-stabilized oscillator circuit (1, 2) according to one or more of the preceding claims, **characterized by**

   - at least one current mirror which feeds the first circuit branch and/or the second circuit branch and to whose output a third resistor is connected, the third resistor having in particular the same temperature coefficient and/or the same resistance as the first and second resistors (R2, R1).

7. Temperature-stabilized oscillator circuit (1, 2), according to one or more of the preceding claims, **characterized**

   - **in that** a first MOS transistor (T2) as controllable upward-integration current source, a second MOS transistor (TS2) for switching the upward-integration operation on and off and the charge storage device (C2) are connected in series in the first circuit branch.

8. Temperature-stabilized oscillator circuit (1, 2) according to one or more of the preceding claims, **characterized**

   - **in that**, in the second circuit branch, the comparator in the form of a third MOS transistor (TC1), the gate terminal of which is connected to the charge storage device (C2), is connected in series with the second resistor (R1), across which is dropped a differential voltage (VR1) formed from the difference between the upper comparator threshold (VCH) and the lower comparator threshold (VCL).

9. Temperature-stabilized oscillator circuit (1, 2) according to one or more of the preceding claims, **characterized**

   - **in that** the controllable downward integration current source in the form of a bipolar transistor (TB3) or a fourth MOS transistor (T9), a fifth MOS transistor (TS3) for switching the downward-integration operation on and off and the charge storage device (C2) are connected in series.

10. Temperature-stabilized oscillator circuit (1, 2), according to one or more of the preceding claims, **characterized**

    - **in that** the charge storage device is formed at least partly as a gate oxide capacitance (C2).

11. Temperature-stabilized oscillator circuit (1, 2) according to one or more of the preceding claims, **characterized by**

    - a sixth MOS transistor (T5), which is connected in series with the third MOS transistor (TC1) and has in particular the same conductivity type as the third MOS transistor (TC1).

12. Temperature-stabilized oscillator circuit (1, 2), according to Claim 11, **characterized**

    - **in that** the sixth MOS transistor (T5) is connected as a diode.

13. Temperature-stabilized oscillator circuit (1, 2) according to one or more of the preceding claims, **characterized**

    - **in that** the first resistor (R2) and the second resistor (R1) have small variations of their temperature coefficient and/or small variations of their absolute value.

14. Temperature-stabilized oscillator circuit (1, 2) according to one or more of the preceding claims, **characterized**

    - **in that** all the resistors (R1, R2, R3, R4, R5) of the oscillator circuit (1, 2) essentially have the same temperature coefficients and, in particular, are of the same type of resistor.

15. Temperature-stabilized oscillator circuit (1, 2) according to one or more of the preceding claims, **characterized**

    - **in that** the oscillator circuit (1, 2) has a fixed substrate, on which the components of the oscillator circuit (1, 2) are monolithically integrated.

16. Temperature-stabilized oscillator circuit (1, 2) according to Claim 15, **characterized**

    - **in that** the oscillator circuit (1, 2) is realized by means of CMOS technology.

**Revendications**

1. Circuit (1, 2) oscillateur stabilisé en température qui repose sur une charge et une décharge cyclique d'un accumulateur (C2) de charge comprenant

- un accumulateur (C2) de charge,
- une source (T2) de courant à intégration qui peut être commandée pour charger l'accumulateur (C2) de charge,
- une source (TB3, T9) de courant à intégration qui peut être commandée pour décharger l'accumulateur (C2) de charge,
- une première résistance (R2) aux bornes de laquelle chute une tension (VREF) de référence,
- une deuxième résistance (R1) aux bornes de laquelle chute une tension qui est proportionnelle à la tension (VREF) de référence, les deux résistances (R1, R2) ayant sensiblement les mêmes coefficients de température,
- un comparateur (TC1) de commande de la source (T2) de courant à intégration de chargement et de la source (TB3, T9) de courant à intégration de déchargement, en fonction de l'état de charge de l'accumulateur (C2) de charge, d'un seuil (VCL) inférieur prescrit du comparateur et d'un seuil (VCH) supérieur prescrit du comparateur,
- une première branche de circuit qui comporte la source (T2) de courant à intégration de chargement qui peut être commandée ou la source (TB3, T9) de courant à intégration de déchargement qui peut être commandée, et
- une deuxième branche de circuit qui comporte le comparateur (TC1) et/ou qui sert à la production des deux seuils (VCL, VCH) du comparateur,

    **caractérisé**

- **en ce qu'**il est prévu un circuit (BGR) de référence d'intervalle de bande pour la production de la tension (VREF) de référence,
- **en ce que** la première résistance (R2) est contenue dans le circuit (BGR) de référence d'intervalle de bande,
- **en ce que** la première branche de circuit et/ou la deuxième branche de circuit a au moins respectivement deux sous-courants superposés l'un à l'autre ayant des variations différentes en fonction de la température, dans lequel
- la première branche de circuit et la deuxième branche de circuit, et notamment au moins une autre branche de circuit du circuit (1, 2) oscillateur, présentent respectivement au moins de temps à autre une somme ou une différence de respectivement deux sous-courants superposés ayant des variations différentes en fonction de la température, et
- les sous-courants peuvent être réglés ou sont réglés de façon à minimiser sensiblement des termes linéaires et des termes au carré, et notamment des termes d'ordre supérieur, de la variation en fonction de la température de la fréquence de l'oscillateur, et
- **en ce que** les sous-courants sont déterminés notamment par le circuit (BGR) de référence d'intervalle de bande.

2. Circuit (1, 2) oscillateur stabilisé en température suivant la revendication 1, **caractérisé**

- **en ce que** la première résistance (R2) et la deuxième résistance (R1) sont des résistances de même type.

3. Circuit (1, 2) oscillateur stabilisé en température suivant la revendication 1 ou 2, **caractérisé**

- **en ce qu'**au moins l'un des sous-courants peut être produit au moyen du circuit (BGR) de référence à intervalle de bande.

4. Circuit (1, 2) oscillateur stabilisé en température suivant l'une des revendications 1 à 3, **caractérisé**

- **en ce que** le circuit (BGR) de référence à intervalle de bande est relié à la première branche de circuit et/ou à la deuxième branche de circuit par au moins un miroir de courant.

5. Circuit (1, 2) oscillateur stabilisé en température suivant la revendication 4, **caractérisé**

- **en ce que** le au moins un miroir de courant est conçu pour l'échange dynamique de composants.

6. Circuit (1, 2) oscillateur stabilisé en température suivant l'une des revendications précédentes, **caractérisé par**

- au moins un miroir de courant qui alimente la première branche de circuit et/ou la deuxième branche de circuit et à la sortie duquel est montée une troisième résistance, la troisième résistance ayant notamment le même coefficient de température et/ou la même valeur que la première et la deuxième résistance (R2, R1).

**7.** Circuit (1, 2) oscillateur stabilisé en température suivant l'une ou plusieurs des revendications précédentes, **caractérisé**

- **en ce que** dans la première branche du circuit, sont montés en série un premier transistor (T2) MOS en tant que source de courant à intégration de chargement pouvant être commandée, un deuxième transistor (TS2) MOS pour faire débuter ou arrêter l'opération à intégration de chargement et l'accumulateur (C2) de charge.

**8.** Circuit (1, 2) oscillateur stabilisé en température suivant l'une ou plusieurs des revendications précédentes, **caractérisé**

- **en ce que** dans la deuxième branche du circuit, le comparateur sous la forme d'un troisième transistor (TC1) MOS dont la borne de grille est reliée à l'accumulateur (C2) de charge est monté en série avec la deuxième résistance (R1) aux bornes de laquelle chute une tension (VR1) de différence qui est formée de la différence entre le seuil (VCH) supérieur du comparateur et le seuil (VCL) inférieur du comparateur.

**9.** Circuit (1, 2) oscillateur stabilisé en température suivant l'une ou plusieurs des revendications précédentes, **caractérisé**

- **en ce que** la source de courant à intégration de déchargement pouvant être commandée sous la forme d'un transistor (TB3) bipolaire ou d'un quatrième transistor (T9) MOS, un cinquième transistor (TS3) MOS pour faire commencer et arrêter l'opération à intégration de déchargement et l'accumulateur (C2) de charge sont montés en série.

**10.** Circuit (1, 2) oscillateur stabilisé en température suivant l'une ou plusieurs des revendications précédentes, **caractérisé**

- **en ce que** l'accumulateur de charge est constitué au moins en partie sous la forme d'une capacité (C2) à oxyde de grille.

**11.** Circuit (1, 2) oscillateur stabilisé en température suivant l'une ou plusieurs des revendications précédentes, **caractérisé par**

- un sixième transistor (T5) MOS qui est monté en série avec le troisième transistor (TC1) MOS et qui a notamment le même type de conductivité que le troisième transistor (TC1) MOS.

**12.** Circuit (1, 2) oscillateur stabilisé en température suivant la revendication 11, **caractérisé**

- **en ce que** le sixième transistor (T5) MOS est monté en diode.

**13.** Circuit (1, 2) oscillateur stabilisé en température suivant l'une ou plusieurs des revendications précédentes, **caractérisé**

- **en ce que** la première résistance (R2) et la deuxième résistance (R1) ont de petites dispersions de leurs coefficients de température et/ou de petites dispersions de leur valeur absolue.

**14.** Circuit (1, 2) oscillateur stabilisé en température suivant l'une ou plusieurs des revendications précédentes, **caractérisé**

- **en ce que** l'ensemble des résistances (R1, R2, R3, R4, R5) du circuit (1, 2) oscillateur ont sensiblement les mêmes coefficients de température et sont notamment du même type de résistance.

**15.** Circuit (1, 2) oscillateur stabilisé en température suivant l'une ou plusieurs des revendications précédentes, **caractérisé**

- **en ce que** le circuit (1, 2) oscillateur a un substrat solide sur lequel les composants du circuit (1, 2) oscillateur sont intégrés monolithiquement.

16. Circuit (1, 2) oscillateur stabilisé en température suivant la revendication 15, **caractérisé**

- **en ce que** le circuit (1, 2) oscillateur est réalisé en technologie CMOS.

Fig. 1

EP 1 446 884 B1

Fig. 2

EP 1 446 884 B1